# EUROPEAN PATENT APPLICATION

(11) **EP 4 686 364 A1**
(43) Date of publication of application: **28.01.2026**
(21) Application number: 25190670.7
(22) Date of filing: 21.07.2025
(51) Int. Cl.: H10K 59/80, H10K 59/128, H10K 59/121

(54) **DISPLAY DEVICE AND ELECTRONIC DEVICE INCLUDING THE SAME**

(30) Priority: 22.07.2024 KR 20240096454
(71) Applicant: Samsung Display Co., Ltd., Yongin-si, Gyeonggi-do 17113 (KR)
(72) Inventor: HONG, SANG MIN, 17113 Yongin-si (KR); KIM, HYOMIN, 17113 Yongin-si (KR)
(74) Representative: Taor, Simon Edward William

(57) **Abstract**

A display device includes a display panel which includes a first unit pixel in a first region, a second unit pixel in a second region, and an encapsulation layer including a first inorganic layer covering the first unit pixel and the second unit pixel, and a light control layer which includes a first light blocking layer in the first region and the second region and having openings defined therein and a second light blocking layer including light blocking pattens in which pattern openings, each overlapping the opening overlapping the second region, are defined. In the first inorganic layer, the first inorganic layer in the first region and the first inorganic layer in the second region have different stacked structures.

## Description

### CROSS-REFERENCE TO RELATED APPLICATION

The present application claims priority to and the benefit of Korean Patent Application No. 10-2024-0096454, filed on July 22, 2024, in the Korean Intellectual Property Office.

### BACKGROUND

Aspects of some embodiments of the present disclosure herein relate to a display device and electronic device.

Electronic devices such as a smart phone, a tablet computer, a laptop computer, a car navigation system, and a smart television are being developed. Such electronic devices are equipped with display devices for providing information.

There are user demands for image quality suitable for an usage situation. For example, users require brighter images outside a building where natural light affects images. For example, users require images with a narrow viewing angle when viewing personal information on a display device.

The above information disclosed in this Background section is only for enhancement of understanding of the background and therefore the information discussed in this Background section does not necessarily constitute prior art.

### SUMMARY

Aspects of some embodiments of the present disclosure herein relate to a display device, and for example, to a display device capable of operating in two modes.

Aspects of some embodiments of the present disclosure include a display device including a display panel which implements identical color purity even at a relatively narrow viewing angle.

According to some embodiments of the present disclosure, a display device includes: a display panel which includes a base substrate including a first region and a second region adjacent to the first region, a first unit pixel in the first region, a second unit pixel in the second region, and an encapsulation layer including a first inorganic layer covering the first unit pixel and the second unit pixel, a second inorganic layer, and an organic layer between the first inorganic layer and the second inorganic layer; and a light control layer which is on the encapsulation layer and includes a first light blocking layer in the first region and the second region and having openings which are defined therein and through which light generated from the first unit pixel and the second unit pixel is transmitted, color filters on the openings, and a second light blocking layer including light blocking patterns in which pattern openings each overlapping the opening in the second region are defined, wherein the first inorganic layer includes a (1-1)-th inorganic layer on the first region and a (1-2)-th inorganic layer on the second region, and the (1-1)-th inorganic layer and the (1-2)-th inorganic layer have different stacked structures.

According to some embodiments, the (1-1)-th inorganic layer may include (1-1)-th to (1-4)-th layers sequentially stacked, and the (1-2)-th inorganic layer may include (2-1)-th to (2-3)-th layers sequentially stacked.

According to some embodiments, the (1-1)-th to (1-4)-th layers included in the (1-1)-th inorganic layer, and the (2-1)-th to (2-3)-th layers included in the (1-2)-th inorganic layer may have different refractive indices, and each may include silicon oxynitride.

According to some embodiments, in the (1-1)-th inorganic layer, the (1-1)-th layer may have a thickness of about 80 nm (800 Å) to about 120 nm (1200 Å), the (1-2)-th layer may have a thickness of about 700 nm (7000 Å) to about 1100 nm (11000 Å), the (1-3)-th layer may have a thickness of about 50 nm (500 Å) to about 90 nm (900 Å), and the (1-4)-th layer may have a thickness of about 60 nm (600 Å) to about 100 nm (1000 Å).

According to some embodiments, in the (1-2)-th inorganic layer, the (2-1)-th layer may have a thickness of about 800 nm (8000 Å) to about 1300 nm (13000 Å), the (2-2)-th layer may have a thickness of about 50 nm (500 Å) to about 90 nm (900 Å), and the (2-3)-th layer may have a thickness of about 60 nm (600 Å) to about 100 nm (1000 Å).

According to some embodiments, the (1-4)-th layer and the (2-3)-th layer may have oxygen content ratios greater than those of the (1-1)-th, (1-3)-th, (2-1)-th and (2-2)-th layers.

According to some embodiments, an area of the pattern opening may be smaller than an area of the opening.

According to some embodiments, a refractive index of the (1-1)-th layer may be smaller than refractive indices of the (1-2)-th layer and the (1-3)-th layer, and may be greater than a refractive index of the (1-4)-th layer, and a refractive index of the (1-3)-th layer may be smaller than a refractive index of the (1-2)-th layer, and may be greater than a refractive index of the (1-4)-th layer.

According to some embodiments, a refractive index of the (2-1)-th layer may be the same as a refractive index of the (1-2)-th layer, a refractive index of the (2-2)-th layer may be the same as a refractive index of the (1-3)-th layer, and a refractive index of the (2-3)-th layer may be the same as a refractive index of the (1-4)-th layer.

According to some embodiments, refractive indices of the (1-4)-th layer and the (2-3)-th layer may be the same as a refractive index of the organic layer.

According to some embodiments, the first unit pixel may include (1-1)-th pixels each configured to provide first color light and spaced apart from each other along a first direction, a (1-2)-th pixel configured to provide second color light different from the first color light and spaced apart from the (1-1)-th pixels in oblique directions with respect to the first direction, and a (1-3)-th pixel configured to provide third color light different from the first color and the second color, spaced apart from the (1-2)-th pixel along a second direction crossing the first direction, and spaced apart from the (1-1)-th pixels in the oblique directions, and the second unit pixel may include (2-1)-th pixels each configured to provide the first color light and spaced apart from each other along the first direction, a (2-2)-th pixel configured to provide the second color light and spaced apart from the (2-1)-th pixels in the oblique directions, and a (2-3)-th pixel configured to provide the third color light, spaced apart from the (2-2)-th pixel along the second direction, and spaced apart from the (2-1)-th pixels in the oblique directions.

According to some embodiments, the first unit pixel and the second unit pixel may be each provided in plurality, four different second unit pixels may be adjacent to each other with respect to the one first unit pixel in the oblique directions, and four different first unit pixels may be adjacent to each other with respect to the one second unit pixel in the oblique directions.

According to some embodiments, the (1-1)-th to (1-3)-th pixels, and the (2-1)-th to (2-3)-th pixels may each include a first electrode, a second electrode, and a light-emitting pattern between the first electrode and the second electrode, and the display panel may further include a protective layer between the second electrode and the first inorganic layer.

According to some embodiments, a refractive index of the protective layer may be greater than refractive indices of the (1-1)-th inorganic layer and the (1-2)-th inorganic layer.

According to some embodiments, the display panel may include a pixel-defining film in which display openings exposing at least a portion of each of the first electrodes and having light-emitting patterns therein are defined, and the openings and the pattern openings may overlap the display openings.

According to some embodiments, the openings may each have either of a circular shape or an oval shape.

According to some embodiments, the pattern openings may each have a circular shape, and areas of the openings may be greater than areas of the pattern openings in a plan view.

According to some embodiments, the light blocking patterns may each have a ring shape.

According to some embodiments, the display device may further include bridge patterns connecting between the light blocking patterns.

According to some embodiments, the light control layer may include a planarization layer covering the color filters and below the second light blocking layer, and an overcoat layer covering the second light blocking layer and on the planarization layer.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a front view of a display device according to some embodiments of the present disclosure;
FIG. 2 is a perspective view of a display device according to some embodiments of the present disclosure;
FIG. 3 is a cross-sectional view of a display device according to some embodiments of the present disclosure;
FIG. 4A is an enlarged plan view illustrating a portion of a display region according to some embodiments of the present disclosure;

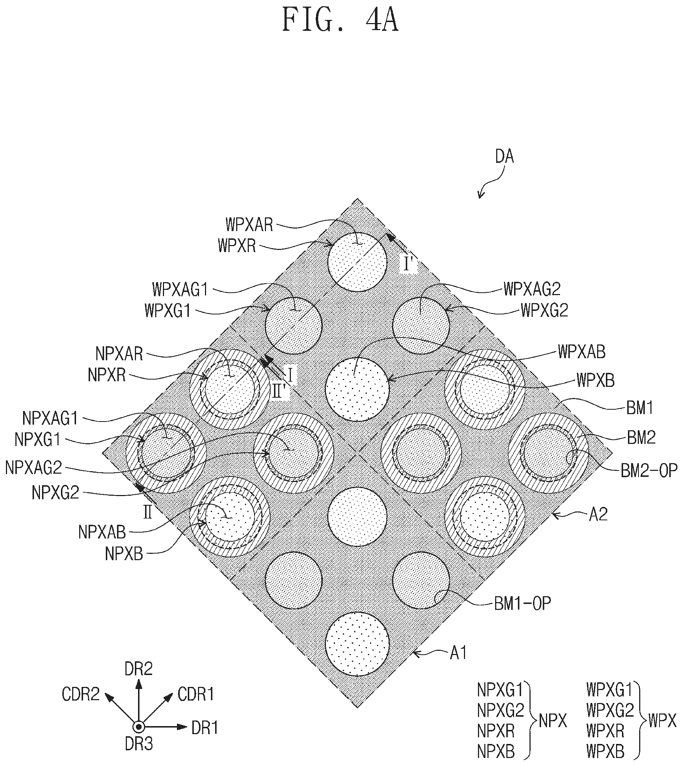

FIG. 4A is an enlarged plan view illustrating a portion of a display region according to some embodiments of the present disclosure;

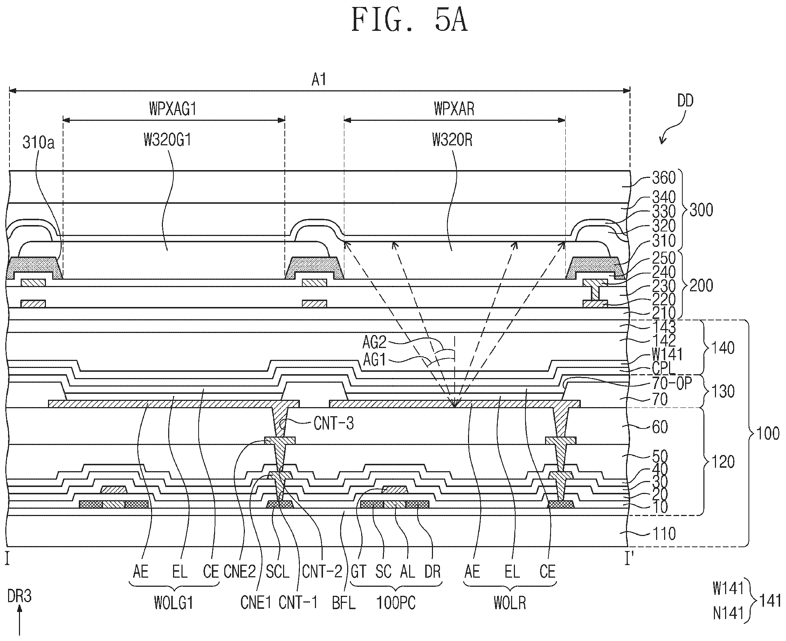

FIG. 5A is a cross-sectional view taken along the line I-I' of FIG. 4A;

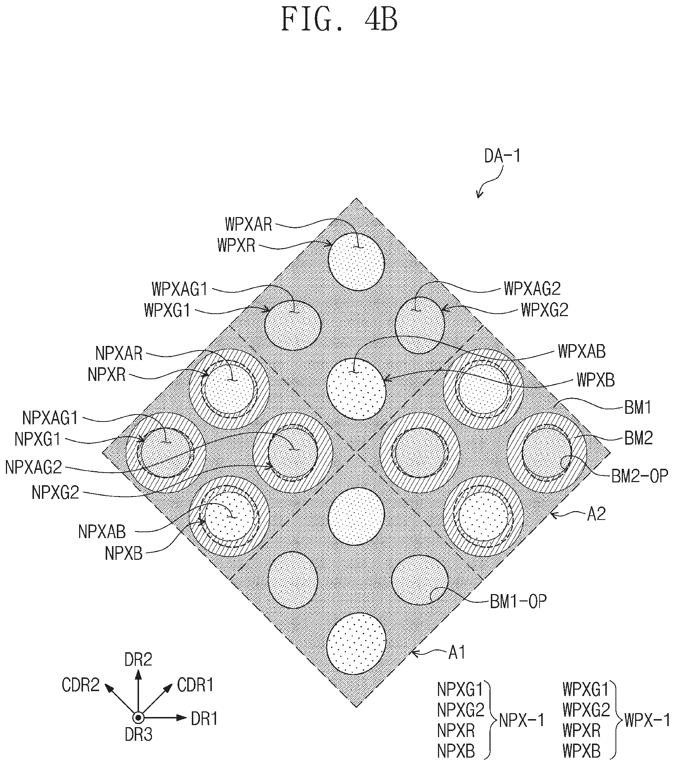

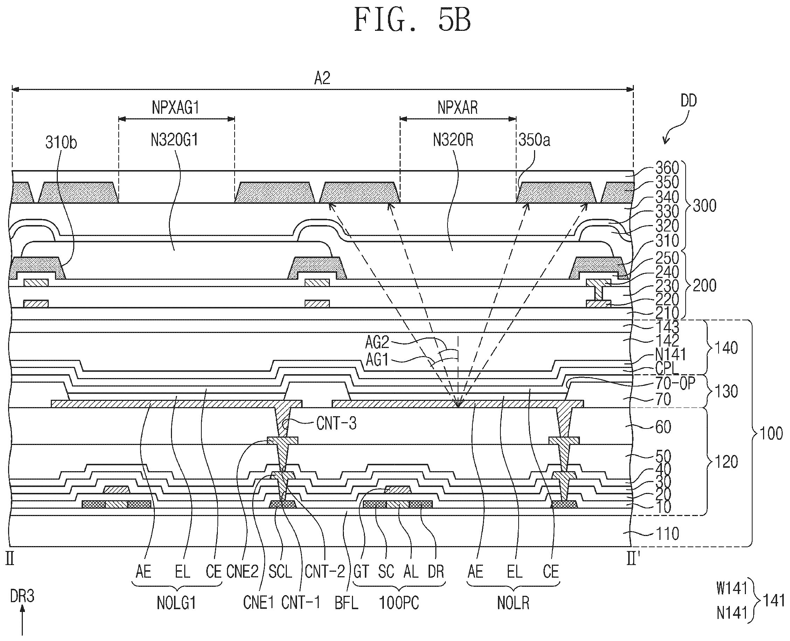

FIG. 5B is a cross-sectional view taken along the line II-II' of FIG. 4B;

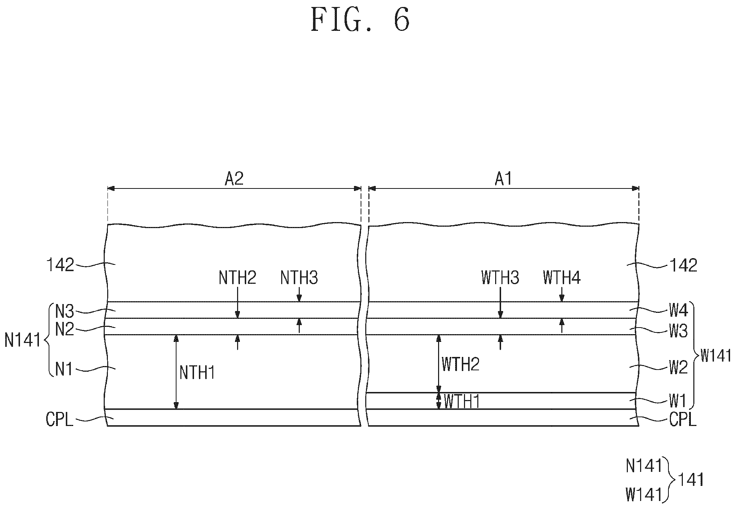

FIG. 6 is an enlarged cross-sectional view of an encapsulation layer according to some embodiments of the present disclosure;

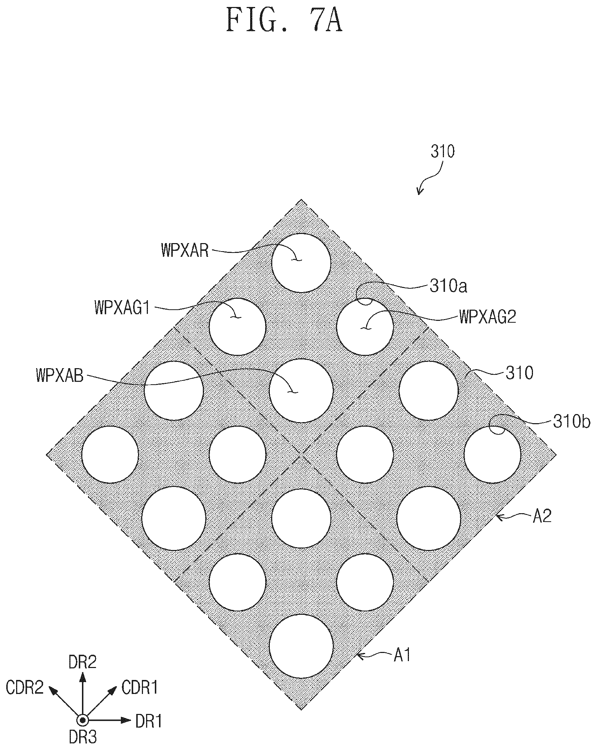

FIG. 7A is an enlarged plan view illustrating a portion of a display region according to some embodiments of the present disclosure;
FIG. 7A is an enlarged plan view illustrating a portion of a display region according to some embodiments of the present disclosure;

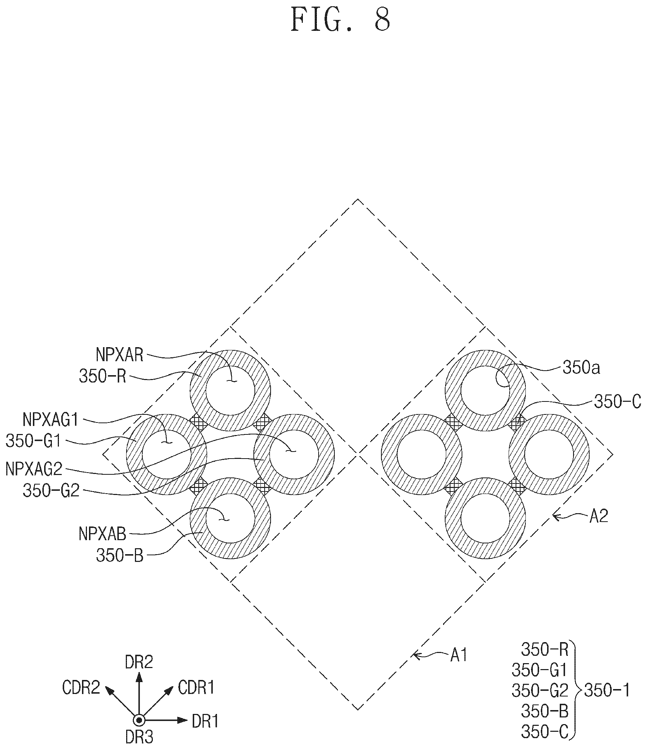

FIG. 8 is an enlarged plan view illustrating a portion of a display region according to some embodiments of the present disclosure; and

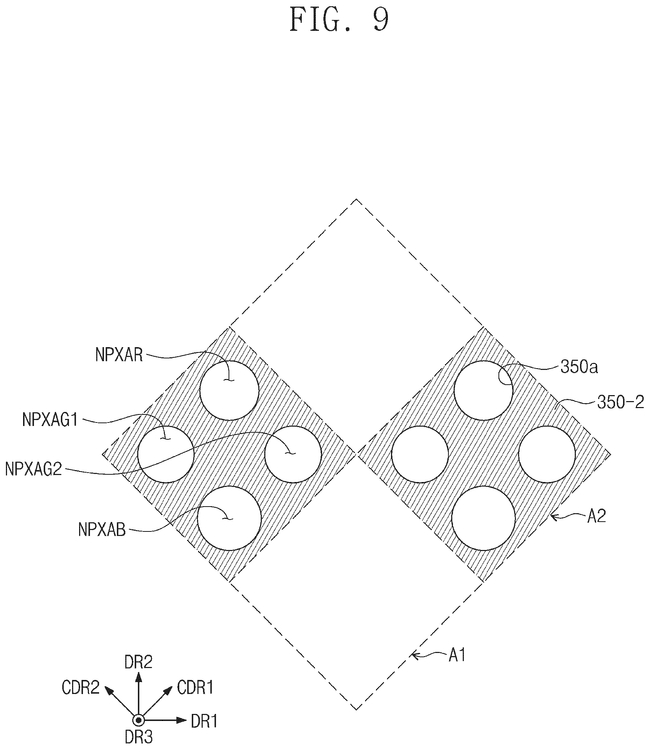

FIG. 9 is an enlarged plan view illustrating a portion of a display region according to some embodiments of the present disclosure.

### DETAILED DESCRIPTION

In this specification, it will be understood that when an element (or region, layer, portion, or the like) is referred to as being "on", "connected to" or "coupled to" another element, it may be directly located/connected/coupled to another element, or intervening elements may be located therebetween.

Like reference numerals or symbols refer to like elements throughout. Also, in the drawings, the thickness, the ratio, and the dimension of the elements are exaggerated for effective description of the technical contents. The term "and/or" includes all of one or more combinations defined by the associated elements.

Although the terms first, second, etc., may be used to describe various elements, these elements should not be limited by these terms. These terms are only used to distinguish one element from another element. For example, a first element may be referred to as a second element, and similarly, a second element may also be referred to as a first element without departing from the scope of the present disclosure. The singular forms include the plural forms as well, unless the context clearly indicates otherwise.

Also, the terms such as "below", "lower", "above", "upper" and the like, may be used for the description to describe one element's relationship to another element illustrated in the figures. It will be understood that the terms have a relative concept and are described on the basis of the orientation depicted in the figures.

It will be understood that the term "includes" or "comprises", when used in this specification, specifies the presence of stated features, integers, steps, operations, elements, components, or a combination thereof, but does not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which the present disclosure belongs. Also, terms, such as those defined in commonly used dictionaries, should be interpreted as having a meaning that is consistent with their meaning in the context of the relevant art and should not be interpreted in an idealized or overly formal sense unless expressly so defined herein.

Hereinafter, embodiments of the present disclosure will be described with reference to the drawings.

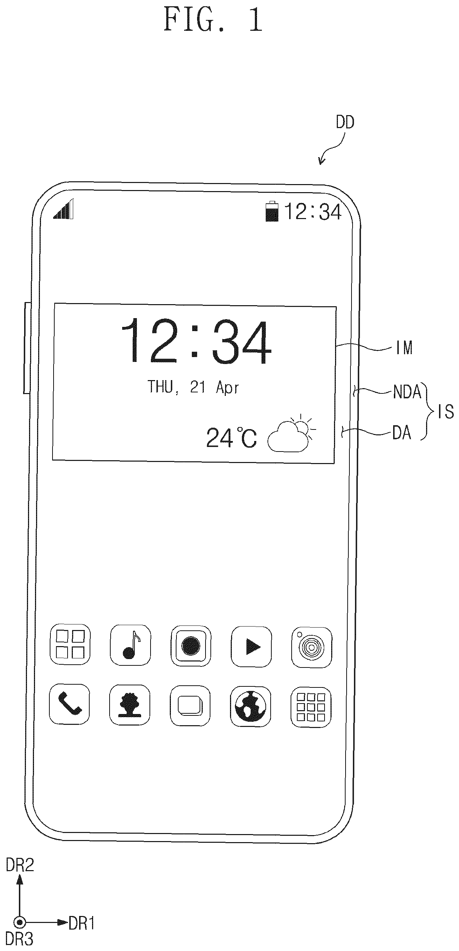

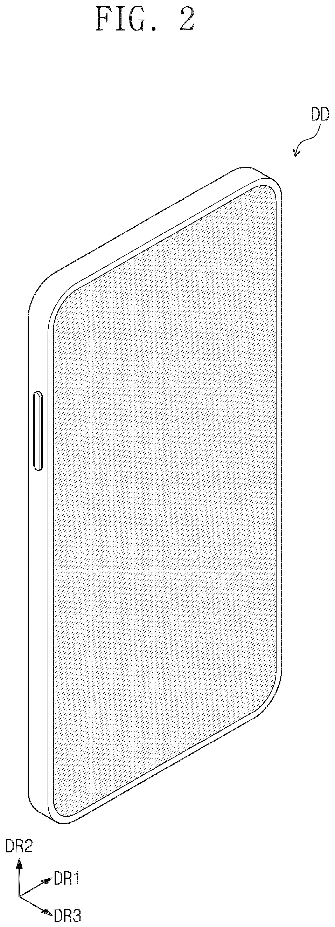

FIG. 1 is a front view of a display device according to some embodiments of the present disclosure. FIG. 2 is a perspective view of a display device according to some embodiments of the present disclosure.

Referring to FIGS. 1 and 2, a display device DD may be a device which is activated according to an electrical signal. The display device DD may be applied to an electronic device such as a mobile phone, a tablet computer, a smart watch, a laptop computer, a desktop computer, and a smart television.

The display device DD may display images, on a display surface IS parallel to each of a first direction DR1 and a second direction DR2. The display surface IS on which images are displayed may correspond to a front surface of the display device DD. The images may include not only dynamic images (e.g., video images) but also static images (e.g., still images). A normal direction of the display surface IS, that is, a thickness direction of the display device DD is indicated by a third direction DR3. A front surface (or upper surface) and a rear surface (or lower surface) of each layer or unit to be described below are defined based on the third direction DR3. As used herein, the phrases "when viewed on a plane" and "in a plan view" may refer to a perspective viewing the display device DD from the third direction DR3.

The display surface IS of the display device DD may be divided into a display region DA and a non-display region NDA. The display region DA may be a region at which images are displayed. The images are viewed by a user through the display region DA. According to some embodiments, the display region DA is illustrated to have a quadrilateral shape with rounded vertices. However, this is illustrated as an example. The display region DA may have various shapes and is not limited to one embodiment.

The non-display region NDA is adjacent to (e.g., in a periphery or outside a footprint of) the display region DA. The non-display region NDA may have a color (e.g., a set or predetermined color). The non-display region NDA may surround the display region DA. Accordingly, a shape of the display region DA may be defined by the non-display region NDA. However, this is illustrated as an example. The non-display region NDA may be located adjacent to only one side of the display region DA or may be omitted. The display device DD according to some embodiments of the present disclosure may include various embodiments, and is not limited to any one embodiment.

FIG. 1 may be a front view of the display device DD which operates in a first mode or a second mode. FIG. 2 may be a side perspective view illustrating the display device DD which operates in the second mode. For example, the first mode may be a normal mode for displaying a screen at a first viewing angle, and the second mode may be a privacy mode for displaying a screen at a second viewing angle narrower than the first viewing angle. The first viewing angle and the second viewing angle may be defined as angles at which images may be viewed without distortion in image quality with respect to the normal direction of the display surface IS.

Referring to FIG. 1, in the first mode or the second mode, when the display device DD is viewed from the front surface (or a direction parallel to the normal direction or the third direction DR3), images IM generated from the display device DD may be viewed by a user. In the second mode, when the display device DD is viewed at an angle exceeding the second viewing angle, the images IM may be invisible.

The second viewing angle in the second mode, and luminance at the second viewing angle may be variously set. In the second mode, when the display device DD is viewed at an angle exceeding the second viewing angle, the images IM may be viewed by a user. For example, the second viewing angle may be 40 degrees (or about 45 degrees), and the luminance at 45 degrees (or about 45 degrees) may be 10 percent (or about 10 percent) of the maximum luminance. In the second mode, the luminance at 45 degrees (or about 45 degrees) may be 20 percent (or about 20 percent) or more. However, embodiments of the present disclosure are not particularly limited thereto.

The display device DD may selectively operate in either of the first mode for displaying a screen at the first viewing angle or the second mode for displaying the screen at the second viewing angle narrower than the first viewing angle. The switching between the first mode and the second mode may be performed by a user, or the first mode may be switched to the second mode when a specific application is executed. For example, the display device DD may be switched from the first mode to the second mode when an application with risk of exposing personal information, such as a bank or memo application, is executed.

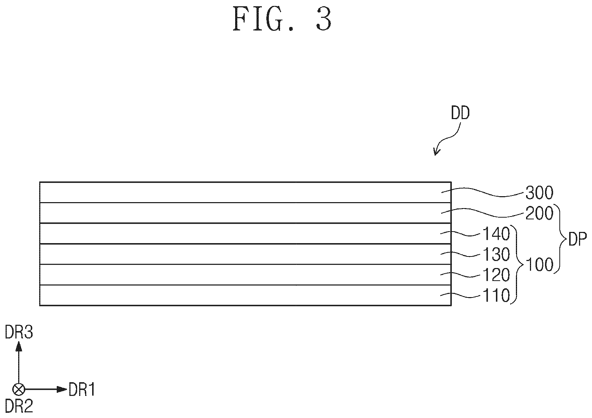

FIG. 3 is a cross-sectional view of a display device according to some embodiments of the present disclosure.

Referring to FIG. 3, a display device DD may include a display panel DP and a light control layer 300. According to some embodiments, a window for forming the exterior of the display device DD may be located on the light control layer 300.

The display panel DP may include a display layer 100 and a sensor layer 200.

The display layer 100 may include a base layer 110, a circuit layer 120, a light-emitting element layer 130, and an encapsulation layer 140. The display layer 100 may be a component which generates images. The display layer 100 may include a light-emitting display layer. For example, the display layer 100 may include an organic light-emitting display layer, an inorganic light-emitting display layer, an organic-inorganic light-emitting display layer, a quantum dot display layer, a micro LED display layer, or a nano LED display layer.

The base layer 110 may be a member which provides a base surface on which the circuit layer 120 is located. The base layer 110 may be a glass substrate, a metal substrate, a silicon substrate, a polymer substrate, etc. However, embodiments of the present disclosure are not limited thereto, and the base layer 110 may be an inorganic layer, an organic layer, or a composite material layer.

The circuit layer 120 may be located on the base layer 110. The circuit layer 120 may include an insulating layer, a semiconductor pattern, a conductive pattern, a signal line, etc. An insulating layer, a semiconductor layer, and a conductive layer are formed on the base layer 110 through coating and deposition, etc., and subsequently, the insulating layer, the semiconductor layer, and the conductive layer may be selectively patterned by performing photolithography processes multiple times. Thereafter, the semiconductor pattern, the conductive pattern, and the signal line included in the circuit layer 120 may be formed.

The light-emitting element layer 130 may be located on the circuit layer 120. The light-emitting element layer 130 may include a light-emitting element. For example, the light-emitting element layer 130 may include an organic light-emitting material, an inorganic light-emitting material, an organic-inorganic light-emitting material, a quantum dot, a quantum rod, a micro LED, or a nano LED.

The encapsulation layer 140 may be located on the light-emitting element layer 130. The encapsulation layer 140 may protect the light-emitting element layer 130 against moisture, oxygen, and foreign substances such as dust particles. The encapsulation layer 140 may include a plurality of inorganic layers and an organic layer located between the inorganic layers. According to some embodiments of the present disclosure, the lower inorganic layers may have stacked structures different from each other in each region. The description thereof will be described later.

The sensor layer 200 may detect an external input applied from the outside. The external input may be a user's input. The user's input may include various types of external inputs such as a part of a user's body, light, heat, pen, or pressure. The sensor layer 200 may be referred to as a sensor, an input-sensing layer, or an input-sensing panel. The sensor layer 200 may be formed through a continuous process with the display layer 100, and be directly located on the display layer 100. However, embodiments of the present disclosure are not particularly limited thereto. For example, the sensor layer 200 may be coupled to the display layer 100 via an adhesive layer. An adhesive member may include a typical bonding agent or adhesive agent.

The light control layer 300 may be located on the sensor layer 200. The light control layer 300 may reduce reflectance for external light incident from the outside of the display device DD. The light control layer 300 may be directly located on the sensor layer 200. However, embodiments of the present disclosure are not limited thereto, and the adhesive member may be located between the light control layer 300 and the sensor layer 200.

FIG. 4A is an enlarged plan view illustrating a portion of a display region according to some embodiments of the present disclosure. FIG. 4A is an enlarged plan view illustrating a portion of a display region according to some embodiments of the present disclosure.

Referring to FIG. 4A, a first unit pixel WPX and a second unit pixel NPX may be located in a display region DA. The first unit pixel WPX may include pixels having relatively wide viewing angles, and the second unit pixel NPX may include pixels having relatively narrow viewing angles.

According to some embodiments of the present disclosure, first regions A1 and second regions A2 may be arranged in the display region DA. One first region A1 may be defined as a region in which one first unit pixel WPX is located, and one second region A2 may be defined as a region in which one second unit pixel NPX is located.

A plurality of first regions A1 and second regions A2 may be arranged in the display region DA. The first regions A1 may be arranged to be spaced apart from each other along the first direction DR1 and the second direction DR2. The second regions A2 may be arranged to be spaced apart from each other along the first direction DR1 and the second direction DR2. According to some embodiments of the present disclosure, the first regions A1 and the second regions A2 may be alternately arranged along a first oblique direction CDR1 and a second oblique direction CDR2. The first regions A1 and the second regions A2 may each be defined to have a rhombic shape on a plane (or in a plan view).

According to some embodiments, four different second regions A2 may be located adjacent to each other with respect to one first region A1 in the first oblique direction CDR1 and the second oblique direction CDR2, and four different first regions A1 may be located adjacent to each other with respect to one second region A2 in the first oblique direction CDR1 and the second oblique direction CDR2. Accordingly, another region may be located adjacent to one side defining a rhombic shape.

The first unit pixel WPX may include (1-1)-th pixels WPXG1 and WPXG2, a (1-2)-th pixel WPXR, and a (1-3)-th pixel WPXB. The (1-1)-th pixels WPXG1 and WPXG2 may provide first color light. The (1-1)-th pixels WPXG1 and WPXG2 may be arranged along the first direction DR1.

The (1-2)-th pixel WPXR may provide second color light different from the first color light. The (1-2)-th pixel WPXR may be spaced apart from one (1-1)-th pixel WPXG1 along the first oblique direction CDR1, and be spaced apart from the other (1-1)-th pixel WPXG2 along the second oblique direction CDR2.

The (1-3)-th pixel WPXB may provide third color light different from the first color light and the second color light. The (1-3)-th pixel WPXB may be spaced apart from one (1-1)-th pixel WPXG1 along the second oblique direction CDR2, and be spaced apart from the other (1-1)-th pixel WPXG2 along the first oblique direction CDR1.

The second unit pixel NPX may include (2-1)-th pixels NPXG1 and NPXG2, a (2-2)-th pixel NPXR, and a (2-3)-th pixel NPXB. The (2-1)-th pixels NPXG1 and NPXG2 may provide the first color light. The (2-1)-th pixels NPXG1 and NPXG2 may be arranged along the first direction DR1.

The (2-2)-th pixel NPXR may provide the second color light. The (2-2)-th pixel NPXR may be spaced apart from one (2-1)-th pixel NPXG1 along the first oblique direction CDR1, and be spaced apart from the other (2-1)-th pixel NPXG2 along the second oblique direction CDR2.

The (2-3)-th pixel NPXB may provide the third color light. The (2-3)-th pixel NPXB may be spaced apart from one (2-1)-th pixel NPXG1 along the second oblique direction CDR2, and be spaced apart from the other (2-1)-th pixel NPXG2 along the first oblique direction CDR1.

According to some embodiments, the first color light may be green, the second color light may be red, and the third color light may be blue. According to some embodiments, the first unit pixel WPX and the second unit pixel NPX may each include one red color pixel, one blue color pixel, and two green color pixels. However, this is merely illustrated as an example, and the number of each pixel may be different therefrom.

Regions in which light provided from the (1-1)-th pixels WPXG1 and WPXG2 is viewed by a user may be defined as (1-1)-th transmission regions WPXAG1 and WPXAG2. Regions in which light provided from the (1-2)-th pixel WPXR is viewed by a user may be defined as (1-2)-th transmission regions WPXAR. Regions in which light provided from the (1-3)-th pixel WPXB is viewed by a user may be defined as (1-3)-th transmission regions WPXAB.

Regions in which light provided from the (2-1)-th pixels NPXG1 and NPXG2 is viewed by a user may be defined as (2-1)-th transmission regions NPXAG1 and NPXAG2. Regions in which light provided from the (2-2)-th pixel NPXR is viewed by a user may be defined as (2-2)-th transmission regions NPXAR. Regions in which light provided from the (2-3)-th pixel NPXB is viewed by a user may be defined as (2-3)-th transmission regions NPXAB.

According to some embodiments of the present disclosure, the transmission regions WPXAG1, WPXAG2, WPXAR, and WPXAB in the first region A1 may be defined by openings BM1-OP included in a first light blocking layer BM1 overlapping the first region A1, and the transmission regions NPXAG1, NPXAG2, NPXAR, and NPXAB in the second region A2 may be defined by pattern openings BM2-OP included in a second light blocking layer BM2. The first light blocking layer BM1 may correspond to a first light blocking layer 310 (see FIG. 5A) to be described later, and the second light blocking layer BM2 may correspond to a second light blocking layer 350 (see FIG. 5B) to be described later.

According to some embodiments of the present disclosure, the first light blocking layer BM1 may be arranged in the entire of the first regions A1 and the second regions A2. The second light blocking layer BM2 may be located only in the second regions A2. The second light blocking layer BM2 may include light blocking patterns having a ring shape. The description thereof will be described later.

According to some embodiments, among the transmission regions defined in the first region A1 and the second region A2, the areas of the transmission regions WPXAR and NPXAR which provide red color light may be greater than the areas of the transmission regions WPXAG1, WPXAG2, NPXAG1, and NPXAG2 which provide green color light, and may be smaller than the areas of the transmission regions WPXAB and NPXAB which provide blue color light.

However, embodiments of the present disclosure are not limited thereto. The transmission regions WPXAG1, WPXAG2, WPXAR, and WPXAB defined in the first region A1 may have the same area, and the transmission regions NPXAG1, NPXAG2, NPXAR, and NPXAB defined in the second region A2 may have the same area. The transmission regions are not limited to any one embodiment.

According to some embodiments, the openings BM1-OP defined in the first light blocking layer BM1 may have a circular shape. Accordingly, the transmission regions WPXAG1, WPXAG2, WPXAR, and WPXAB defined in the first regions A1 may have a circular shape on a plane (or in a plan view).

The pattern opening BM2-OP defined in each of the light blocking patterns of the second light blocking layer BM2 may have a circular shape. Accordingly, the transmission regions NPXAG1, NPXAG2, NPXAR, and NPXAB defined in the second regions A2 may have a circular shape on a plane (or in a plan view).

According to some embodiments, the area of the opening BM1-OP may be greater than the area of the pattern opening BM2-OP. Accordingly, the areas of the transmission regions WPXAG1, WPXAG2, WPXAR, and WPXAB defined in the first region A1 may be greater than the areas of the transmission regions NPXAG1, NPXAG2, NPXAR, and NPXAB defined in the second region A2.

When the display device DD (see FIG. 2) according to embodiments of the present disclosure operates in the second mode which is a privacy mode, light may not be provided to the transmission regions defined in the first region A1, but light may be provided only to the transmission regions defined in the second region A2. Therefore, in the second mode, the images IM (see FIG. 1) may be invisible when the display device DD is viewed at an angle exceeding the certain viewing angle.

The description of FIG. 4B will be mainly focused on the differences from that of FIG. 4A.

Referring to FIG. 4B, a first unit pixel WPX-1 and a second unit pixel NPX-1 may be located in a display region DA-1. The first unit pixel WPX-1 may include pixels having relatively wide viewing angles, and the second unit pixel NPX-1 may include pixels having relatively narrow viewing angles.

According to some embodiments of the present disclosure, first regions A1 and second regions A2 may be arranged in the display region DA-1. One first region A1 may be defined as a region in which one first unit pixel WPX-1 is located, and one second region A2 may be defined as a region in which one second unit pixel NPX-1 is located.

The first unit pixel WPX-1 may include (1-1)-th pixels WPXG1 and WPXG2, a (1-2)-th pixel WPXR, and a (1-3)-th pixel WPXB. The second unit pixel NPX-1 may include (2-1)-th pixels NPXG1 and NPXG2, a (2-2)-th pixel NPXR, and a (2-3)-th pixel NPXB.

Transmission regions WPXAG1, WPXAG2, WPXAR, and WPXAB in the first region A1 may be defined by openings BM1-OP included in a first light blocking layer BM1 overlapping the first region A1, and transmission regions NPXAG1, NPXAG2, NPXAR, and NPXAB in the second region A2 may be defined by pattern openings BM2-OP included in a second light blocking layer BM2.

According to some embodiments, the shape of each of the openings BM1-OP defined in the first light blocking layer BM1 may differ from the shape of the pattern opening BM2-OP defined in each of the light blocking patterns of the second light blocking layer BM2. For example, the openings BM1-OP defined in the first light blocking layer BM1 may have an oval shape. Accordingly, the transmission regions WPXAG1, WPXAG2, WPXAR, and WPXAB defined in the first regions A1 may have an oval shape on a plane (or in a plan view). The openings BM1-OP may have an oval shape with a certain rule, or a random oval shape.

The pattern opening BM2-OP defined in each of the light blocking patterns of the second light blocking layer BM2 may have a circular shape. Accordingly, the transmission regions NPXAG1, NPXAG2, NPXAR, and NPXAB defined in the second regions A2 may have a circular shape on a plane (or in a plan view).

However, embodiments of the present disclosure are not limited thereto. The pattern opening BM2-OP defined in each of the light blocking patterns of the second light blocking layer BM2 may have an oval shape corresponding to the overlapped opening BM1-OP, and is not limited to any one embodiment.

According to some embodiments, the area of the opening BM1-OP may be greater than the area of the pattern opening BM2-OP. Accordingly, the areas of the transmission regions WPXAG1, WPXAG2, WPXAR, and WPXAB defined in the first region A1 may be greater than the areas of the transmission regions NPXAG1, NPXAG2, NPXAR, and NPXAB defined in the second region A2. The openings BM2-OP defined in the second region A2 are indicated as a dotted line.

According to some embodiments, among the transmission regions defined in the first region A1 and the second region A2, the areas of the transmission regions WPXAR and NPXAR which provide red color light may be greater than the areas of the transmission regions WPXAG1, WPXAG2, NPXAG1, and NPXAG2 which provide green color light, and may be smaller than the areas of the transmission regions WPXAB and NPXAB which provide blue color light.

FIG. 5A is a cross-sectional view taken along the line I-I' of FIG. 4A. FIG. 5B is a cross-sectional view taken along the line II-II' of FIG. 4B. FIG. 6 is an enlarged cross-sectional view of an encapsulation layer according to some embodiments of the present disclosure. FIG. 7A is an enlarged plan view illustrating a portion of a display region according to some embodiments of the present disclosure. FIG. 7A is an enlarged plan view illustrating a portion of a display region according to some embodiments of the present disclosure.

FIG. 5A is a cross-sectional view of a first region A1 in a display device DD, and FIG. 5B is a cross-sectional view of a second region A2 in the display device DD.

Referring to FIGS. 5A and 5B, at least one inorganic layer is formed on an upper surface of a base layer 110. The inorganic layer may include at least one of aluminum oxide, titanium oxide, silicon oxide, silicon nitride, silicon oxynitride, zirconium oxide, or hafnium oxide. The inorganic layer may be formed as a multi-layer. The multi-layered inorganic layers may constitute a barrier layer and/or a buffer layer. According to some embodiments, a display layer 100 is illustrated to include a buffer layer BFL.

The buffer layer BFL may relatively improve a bonding force between the base layer 110 and a semiconductor pattern. The buffer layer BFL may include at least one of silicon oxide, silicon nitride, or silicon oxynitride. For example, the buffer layer BFL may have a structure in which a silicon oxide layer and a silicon nitride layer are alternately stacked.

The semiconductor pattern may be located on the buffer layer BFL. The semiconductor pattern may include polysilicon. However, embodiments of the present disclosure are not limited thereto, and the semiconductor pattern may also include amorphous silicon, low-temperature polycrystalline silicon, or an oxide semiconductor.

FIGS. 5A and 5B merely illustrate a portion of the semiconductor pattern, and the semiconductor pattern may be further located in other regions. The semiconductor pattern may be arranged across pixels in accordance with the specific rule. The electrical properties of the semiconductor pattern may vary depending on whether to be doped or not. The semiconductor pattern may include a first region having high conductivity and a second region having low conductivity. The first region may be doped with an N-type dopant or a P-type dopant. A P-type transistor may include a doped region which is doped with the P-type dopant, and an N-type transistor may include a doped region which is doped with the N-type dopant. The second region may be a non-doped region or a region doped at a concentration lower than that of the first region.

The conductivity of the first region may be greater than the conductivity of the second region, and serve as an electrode or a signal line. The second region may correspond to an active region (or a channel) of a transistor. That is, a portion of the semiconductor pattern may be the active region of the transistor, another portion may be a source or a drain of the transistor, and still another portion may be a connection electrode or a connection signal line.

The pixels may each include a pixel circuit and a light-emitting element. The pixel circuit may include a plurality of transistors and at least one capacitor. FIGS. 5A and 5B exemplarily illustrate a transistor 100PC among a plurality of transistors.

A source region SC, an active region AL, and a drain region DR of the transistor 100PC may be formed from the semiconductor pattern. The source region SC and the drain region DR may extend, on a cross section, from the active region AL in directions opposite to each other. FIGS. 5A and 5B illustrate a portion of a connection signal line SCL formed from the semiconductor pattern. According to some embodiments, the connection signal line SCL may be connected to the drain region DR of the transistor 100PC on a plane (or in a plan view).

A first insulating layer 10 may be located on the buffer layer BFL. The first insulating layer 10 may overlap a plurality of pixels in common and cover the semiconductor pattern. The first insulating layer 10 may be an inorganic layer and/or an organic layer and have a single- or multi-layered structure. The first insulating layer 10 may include at least one of aluminum oxide, titanium oxide, silicon oxide, silicon nitride, silicon oxynitride, zirconium oxide, or hafnium oxide. According to some embodiments, the first insulating layer 10 may be a single-layered silicon oxide layer. An insulating layer of a circuit layer 120 to be described later may be an inorganic layer and/or an organic layer as well as the first insulating layer 10, and have a single- or multi-layered structure. The inorganic layer may include at least one of the above-described materials, but is not limited thereto.

A gate GT of each of the transistors 100PC is located on the first insulating layer 10. The gate GT may be a portion of a metal pattern. The gate GT overlaps the active region AL. During a process of doping the semiconductor pattern, the gate GT may function as a mask.

A second insulating layer 20 may be located on the first insulating layer 10 and cover the gate GT. The second insulating layer 20 may overlap the pixels in common. The second insulating layer 20 may be an inorganic layer and/or an organic layer, and have a single- or multi-layered structure. The second insulating layer 20 may include at least one of silicon oxide, silicon nitride, or silicon oxynitride. According to some embodiments, the second insulating layer 20 may have a multi-layered structure in which a silicon oxide layer and a silicon nitride layer are included.

A third insulating layer 30 may be located on the second insulating layer 20. The third insulating layer 30 may have a single- or multi-layered structure. For example, the third insulating layer 30 may have a multi-layered structure in which a silicon oxide layer and a silicon nitride layer are included.

A first connection electrode CNE1 may be located on the third insulating layer 30. The first connection electrode CNE1 may be connected to the connection signal line SCL via a contact hole CNT-1 which passes through the first, second, and third insulating layers 10, 20, and 30.

A fourth insulating layer 40 may be located on the third insulating layer 30. The fourth insulating layer 40 may be a single-layered silicon oxide layer. A fifth insulating layer 50 may be located on the fourth insulating layer 40. The fifth insulating layer 50 may be an organic layer.

A second connection electrode CNE2 may be located on the fifth insulating layer 50. The second connection electrode CNE2 may be connected to the first connection electrode CNE1 via a contact hole CNT-2 which passes through the fourth insulating layer 40 and the fifth insulating layer 50.

A sixth insulating layer 60 may be located on the fifth insulating layer 50 and cover the second connection electrode CNE2. The sixth insulating layer 60 may be an organic layer.

Referring further to FIG. 4A, alight-emitting element layer 130 may be located on the circuit layer 120. The (1-1)-th and (1-2)-th pixels WPXG1 and WPXR included in the first unit pixel WPX may be located in the light-emitting element layer 130 overlapping the first region A1, and the (2-1)-th and (2-2)-th pixels NPXG1 and NPXR included in the second unit pixel NPX may be located in the light-emitting element layer 130 overlapping the second region A2. The configurations, of the (1-3)-th pixel WPXB and the (2-3)-th pixel NPXB on a cross section, which are described in FIG. 4A may be the same as those illustrated in cross-sectional views of pixels to be described later.

Light-emitting elements WOLG1 and WOLR included in the (1-1)-th and (1-2)-th pixels WPXG1 and WPXR, and light-emitting elements NOLG1 and NOLR included in the (2-1)-th and (2-2)-th pixels NPXG1 and NPXR may each include a first electrode AE, a light-emitting pattern EL, and a second electrode CE. The second electrode CE may be formed in the entire of the first region A1 and the second region A2. Accordingly, the second electrode CE may be a common electrode.

The first electrode AE may be located on the sixth insulating layer 60. The first electrode AE may be connected to the second connection electrode CNE2 via a contact hole CNT-3 defined in the sixth insulating layer 60.

A pixel-defining film 70 may be located on the sixth insulating layer 60 and cover a portion of the first electrode AE. A display opening 70-OP which exposes at least a portion of the first electrode AE is defined in the pixel-defining film 70.

The light-emitting pattern EL may be located inside the display opening 70-OP. The light-emitting pattern EL may be individually patterned for each pixel. The individually patterned light-emitting patterns EL may emit light different from each other. However, embodiments of the present disclosure are not limited thereto. The light-emitting patterns EL may be connected to each other, and also be included in a plurality of light-emitting elements in common. In this case, the light-emitting patterns EL may provide blue color light, or also provide white color light.

The second electrode CE may be located on the light-emitting patterns EL. The second electrode CE may have an integrated shape and be included in the plurality of pixels in common.

A hole control layer may be located between the first electrodes AE and the light-emitting patterns EL. The hole control layer may include a hole transport layer, and further include a hole injection layer. An electron control layer may be located between the light-emitting patterns EL and the second electrode CE. The electron control layer may include an electron transport layer and further include an electron injection layer. The hole control layer and the electron control layer may be formed, in common, for the plurality of pixels by using an open mask or through an inkjet process.

The display device DD according to some embodiments may include a protective layer CPL located on the second electrode CE. The protective layer CPL may be formed in the entire of the first region A1 and the second region A2. Accordingly, the protective layer CPL may be a common electrode. The protective layer CPL may function, in a subsequent process, to protect components included in the light-emitting elements WOLG1, WOLR, NOLG1, and NOLR. The protective layer CPL may have a refractive index of 2.0 (or about 2.0).

An encapsulation layer 140 may be located on the light-emitting element layer 130. The encapsulation layer 140 may include a first inorganic layer 141, an organic layer 142, and a second inorganic layer 143 which are sequentially stacked, but the layers constituting the encapsulation layer 140 are not limited thereto. The first and second inorganic layers 141 and 143 may protect the light-emitting element layer 130 against moisture and oxygen, and the organic layer 142 may protect the light-emitting element layer 130 against foreign substances such as dust particles. The first and second inorganic layers 141 and 143 may include an inorganic material. For example, the first and second inorganic layers 141 and 143 may each include one of silicon nitride, silicon oxynitride, silicon oxide, titanium oxide, or aluminum oxide. The organic layer 142 may include an acrylate-based organic layer, but is not particularly limited thereto.

The first inorganic layer 141 according to some embodiments of the present disclosure may include a (1-1)-th inorganic layer W141 and a (1-2)-th inorganic layer N141. The (1-1)-th inorganic layer W141 may be located in the first region A1, and the (1-2)-th inorganic layer N141 may be located in the second region A2. According to some embodiments of the present disclosure, the (1-1)-th inorganic layer W141 and the (1-2)-th inorganic layer N141 may have different stacked structures.

According to some embodiments of the present disclosure, the display device DD including a privacy mode may have the issue that a color in the display region DA (see FIG. 1) shifts towards a reddish direction at a high angle. The display device DD according to some embodiments of the present disclosure may provide an identical image to a user without occurrence of a color shift phenomenon at a specific angle by varying stacked structures of the (1-1)-th inorganic layer W141 located in the first region A1 and the (1-2)-th inorganic layer N141 located in the second region A2 to relatively improve a color sense of the display region DA at a high angle. Hereinafter, the (1-1)-th inorganic layer W141 and the (1-2)-th inorganic layer N141 will be described with reference to FIG. 6.

FIG. 6 is an enlarged cross-sectional view of the (1-1)-th inorganic layer W141 and the (1-2)-th inorganic layer N141. The (1-1)-th inorganic layer W141 and the (1-2)-th inorganic layer N141 may each be located on the protective layer CPL. The (1-1)-th inorganic layer W141 may include (1-1)-th to (1-4)-th layers W1, W2, W3, and W4, and the (1-2)-th inorganic layer N141 may include (2-1)-th to (2-3)-th layers N1, N2, and N3.

The total thickness of the (1-1)-th inorganic layer W141 may be greater than or the same as the total thickness of the (1-2)-th inorganic layer N141.

According to some embodiments of the present disclosure, the (1-1)-th to (1-4)-th layers W1, W2, W3, and W4, and the (2-1)-th to (2-3)-th layers N1, N2, and N3 may each include silicon oxynitride. The (1-1)-th to (1-4)-th layers W1, W2, W3, and W4 and the (2-1)-th to (2-3)-th layers N1, N2, and N3 may respectively have different refractive indices.

The (1-1)-th layer W1 may be located on the protective layer CPL and be in contact with the protective layer CPL. When the protective layer CPL is omitted, the (1-1)-th layer W1 may be located on the second electrode CE illustrated in FIG. 4A. The (1-1)-th layer W1 may have a (1-1)-th thickness WTH1. The (1-1)-th thickness WTH1 may be 80 nm (800 Å) to 120 nm (1200 Å) (or about 80 nm to about 120 nm). The refractive index of the (1-1)-th layer W1 may be smaller than the refractive index of the protective layer CPL. For example, the (1-1)-th layer W1 may have a refractive index of 1.57 (or about 1.57).

The (1-2)-th layer W2 may be located on the (1-1)-th layer W1 and be in contact with the (1-1)-th layer W1. The (1-2)-th layer W2 may have a (1-2)-th thickness WTH2. The (1-2)-th thickness WTH2 may be 700 nm (7000 Å) to 1100 nm (11000 Å) (or about 700 nm to about 1100 nm). The refractive index of the (1-2)-th layer W2 may be greater than the refractive index of the (1-1)-th layer W1. For example, the (1-2)-th layer W2 may have a refractive index of 1.77 (or about 1.77).

The (1-3)-th layer W3 may be located on the (1-2)-th layer W2 and be in contact with the (1-2)-th layer W2. The (1-3)-th layer W3 may have a (1-3)-th thickness WTH3. The (1-3)-th thickness WTH3 may be 50 nm (500 Å) to 90 nm (900 Å) (or about 50 nm to about 90 nm). The refractive index of the (1-3)-th layer W3 may be greater than the refractive index of the (1-1)-th layer W1, and be smaller than the refractive index of the (1-2)-th layer W2. For example, the (1-3)-th layer W3 may have a refractive index of 1.62 (or about 1.62).

The (1-4)-th layer W4 may be located on the (1-3)-th layer W3 and be in contact with the (1-3)-th layer W3. The (1-4)-th layer W4 may have a (1-4)-th thickness WTH4. The (1-4)-th thickness WTH4 may be 60 nm (600 Å) to 100 nm (1000 Å) (or about 60 nm to about 100 nm). The refractive index of the (1-4)-th layer W4 may be smaller than the refractive index of the (1-1)-th layer W1. For example, the (1-4)-th layer W4 may have a refractive index of 1.50 (or about 1.50). According to some embodiments of the present disclosure, the refractive index of the (1-4)-th layer W4 may be the same as the refractive index of the organic layer 142.

The (1-1)-th layer W1 may be a functional layer which controls light. The (1-2)-th layer W2 may be a layer having a relatively higher density than other layers in the (1-1)-th inorganic layer W141. The (1-3)-th layer W3 may provide a flat layer as a buffer layer. The (1-4)-th layer W4 and the organic layer 142 have the same refractive index, and thus the organic layer 142 may be more easily formed on the (1-4)-th layer W4.

According to some embodiments of the present disclosure, refractive indices from the protective layer CPL to the (1-3)-th layer W3 may be formed in a stacked structure in which layers include a high refractive index-a low refractive index-a high refractive index-a low refractive index in this order. Accordingly, the resonance properties of light generated from the light-emitting pattern EL (see FIG. 5A) may be relatively improved. As a result, it may be possible to relatively improve the color shift phenomenon which occurs when the first region A1 is viewed at a high angle (for example, an angle of 60 degrees (or about 60 degrees) or more with respect to one side of the display region DA (see FIG. 1)). Therefore, the display device DD with relatively improved quality may be provided.

The (2-1)-th layer N1 may be located on the protective layer CPL and be in contact with the protective layer CPL. When the protective layer CPL is omitted, the (2-1)-th layer N1 may be located on the second electrode CE illustrated in FIG. 5B. The (2-1)-th layer N1 may have a (2-1)-th thickness NTH1. The (2-1)-th thickness NTH1 may be 800 nm (8000 Å) to 1300 nm (13000 Å) (or about 800 nm to about 1300 nm). The refractive index of the (2-1)-th layer N1 may be smaller than the refractive index of the protective layer CPL. For example, the (2-1)-th layer N1 may have a refractive index in a range of 1.77 (or about 1.77).

The (2-2)-th layer N2 may be located on the (2-1)-th layer N1 and be in contact with the (2-1)-th layer N1. The (2-2)-th layer N2 may have a (2-2)-th thickness NTH2. The (2-2)-th thickness NTH2 may be 50 nm (500 Å) to 90 nm (900 Å) (or about 50 nm to about 90 nm). The refractive index of the (2-2)-th layer N2 may be smaller than the refractive index of the (2-1)-th layer N1. For example, the (2-2)-th layer N2 may have a refractive index of 1.62 (or about 1.62).

The (2-3)-th layer N3 may be located on the (2-2)-th layer N2 and be in contact with the (2-2)-th layer N2. The (2-3)-th layer N3 may have a (2-3)-th thickness NTH3. The (2-3)-th thickness NTH3 may be 60 nm (600 Å) to 100 nm (1000 Å) (or about 60 nm to about 100 nm). The refractive index of the (2-3)-th layer N3 may be smaller than the refractive indices of the (2-1)-th layer N1 and the (2-2)-th layer N2. For example, the (2-3)-th layer N3 may have a refractive index of 1.50 (or about 1.50). According to some embodiments of the present disclosure, the refractive index of the (2-3)-th layer N3 may be the same as the refractive index of the organic layer 142. According to some embodiments, the (1-4)-th layer W4 and the (2-3)-th layer N3 may have oxygen content ratios greater than those of other layers (e.g., the (1-1)-th layer W1, the (1-2)-th layer W2, the (1-3)-th layer W3, the (2-1)-th layer N1 and the (2-2)-th layer N2) in the (1-1)-th inorganic layer W141 and the (1-2)-th inorganic layer N141.

The (2-1)-th layer N1 may be a layer having a relatively higher density than other layers in the (1-2)-th inorganic layer N141. The (2-2)-th layer N2 may provide a flat layer as a buffer layer. The (2-3)-th layer N3 and the organic layer 142 have the same refractive index, and thus the organic layer 142 may be more easily formed on the (2-3)-th layer N3.

The (1-1)-th to (1-4)-th layers W1, W2, W3, and W4 of the (1-1)-th inorganic layer W141, and the (2-1)-th to (2-3)-th layers N1, N2, and N3 of the (1-2)-th inorganic layer N141 may each be formed through plasma enhanced chemical vapor deposition (PECVD).

Layers including the same refractive index among a plurality of layers may be formed through the same process. For example, the (1-2)-th layer W2 and the (2-1)-th layer N1 may be formed through the same process, the (1-3)-th layer W3 and the (2-2)-th layer N2 may be formed through the same process, and the (1-4)-th layer W4 and the (2-3)-th layer N3 may be formed through the same process.

A mask may be used during a process of forming the (1-1)-th layer W1. When the (1-1)-th layer W1 is formed on the protective layer CPL, the mask may be located on the second region A2. Accordingly, the (1-1)-th layer W1 may not be formed in the second region A2, and the (1-1)-th layer W1 may be selectively formed only in the first region A1. Thereafter, processes of forming the (1-2)-th layer W2 and the (2-1)-th layer N1 in the first region A1 and the second region A2 may be performed.

Referring again to FIGS. 5A and 5B, a sensor layer 200 may be directly located on the display layer 100. The sensor layer 200 may be formed on the display layer 100 through a continuous process. The sensor layer 200 may be referred to as a sensor, an input-sensing layer, or an input-sensing panel. The sensor layer 200 may include a sensor base layer 210, a first conductive layer 220, an intermediate insulating layer 230, a second conductive layer 240, and a sensor cover layer 250.

The sensor base layer 210 may be directly located on the display layer 100. The sensor base layer 210 may be an inorganic layer which includes at least one of silicon nitride, silicon oxynitride, or silicon oxide. Alternatively, the sensor base layer 210 may also be an organic layer which includes an epoxy resin, an acrylic resin, or an imide-based resin. The sensor base layer 210 may have a single-layered structure or a multi-layered structure in which layers are stacked along the third direction DR3.

The first conductive layer 220 and the second conductive layer 240 may each have a single-layered structure or a multi-layered structure in which layers are stacked in the third direction DR3.

The conductive layer having the single-layered structure may include a metal layer or a transparent conductive layer. The metal layer may include molybdenum (Mo), silver (Ag), titanium (Ti), copper (Cu), aluminum (Al) or alloys thereof. The transparent conductive layer may include a transparent conductive oxide, such as indium tin oxide, indium zinc oxide, zinc oxide or indium zinc tin oxide. In addition, the transparent conductive layer may include a conductive polymer, such as poly(3,4-ethylenedioxythiophene) (PEDOT), a metal nanowire, graphene, etc.

The conductive layer having the multi-layered structure may include metal layers. The metal layers may have, for example, a three-layered structure of titanium/aluminum/titanium. The conductive layer having the multi-layered structure may include at least one metal layer and at least one transparent conductive layer.

The intermediate insulating layer 230 may be located between the first conductive layer 220 and the second conductive layer 240. The intermediate insulating layer 230 may include an inorganic film. The inorganic film may include at least one of aluminum oxide, titanium oxide, silicon oxide, silicon nitride, silicon oxynitride, zirconium oxide, or hafnium oxide.

Alternatively, the intermediate insulating layer 230 may include an organic film. The organic film may include at least one of an acylate-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, or a perylene-based resin.

The sensor cover layer 250 may be located on the intermediate insulating layer 230 and cover the second conductive layer 240. The second conductive layer 240 may include a conductive pattern. The sensor cover layer 250 may cover the conductive pattern, and thus the probability that damage occurs in the conductive pattern during a subsequent process may be reduced or eliminated. The sensor cover layer 250 may include an inorganic material. For example, the sensor cover layer 250 may include silicon nitride, but is not particularly limited thereto. According to some embodiments of the present disclosure, the sensor cover layer 250 may be omitted.

A light control layer 300 may be located on the sensor layer 200. The light control layer 300 may include a first light blocking layer 310, a plurality of first color filters 320, a cover inorganic layer 330, a planarization layer 340, a second light blocking layer 350, and an overcoat layer 360.

The first light blocking layer 310 to be described with reference to FIGS. 5A and 5B may correspond to the first light blocking layer BM1 illustrated in FIGS. 4A and 4B. Accordingly, the opening BM1-OP defined in the first region A1 of FIGS. 4A and 4B may correspond to an opening 310a defined in the first region A1 of FIG. 5A, and the opening BM2-OP (indicated by a dotted line) defined in the second region A2 of FIGS. 4A and 4B may correspond to an opening 310b defined in the second region A2 of FIG. 5B.

According to some embodiments of the present disclosure, the first light blocking layer 310 may be located in the first region A1 and the second region A2 in common. The first light blocking layer 310 may be arranged to overlap a conductive pattern of the second conductive layer 240. The first light blocking layer 310 may be directly located on the sensor cover layer 250. The first light blocking layer 310 may prevent or reduce reflection of external light due to the second conductive layer 240.

A material constituting the first light blocking layer 310 is not particularly limited as long as the material absorbs light. The first light blocking layer 310 is a layer having a black color, and according to some embodiments, the first light blocking layer 310 may include a black coloring agent. The black coloring agent may include a black dye and a black pigment. The black coloring agent may include carbon black, metal such as chromium, or oxides thereof.

The first and second openings 310a and 310b may be defined in the first light blocking layer 310. FIG. 7A illustrates a shape of the first light blocking layer 310 located in first regions A1 and second regions A2 on a plane (or in a plan view). The first openings 310a defined in the first regions A1 and the second openings 310b defined in the second regions A2 may each have a circular shape. The first openings 310a and the second openings 310b may have the same area.

However, embodiments of the present disclosure are not limited thereto, and among the areas of the openings transmitting light having a corresponding color, the area of the opening located in the first region A1 may be greater than the area of the opening located in the second region A2.

Also, the shapes of the first openings 310a and the second openings 310b may be, on a plane (or in a plan view), the same as the shapes of the display openings 70-OP (see FIG. 5A) defined in the pixel-defining film 70 (see FIG. 5A), and are not limited to any one embodiment.

According to some embodiments of the present disclosure, the transmission regions WPXAG1, WPXAG2, WPXAR, and WPXAB through which light generated from the first unit pixel WPX (see FIG. 4A) is transmitted may be defined by the openings 310a defined in the first region A1 of the first light blocking layer 310.

The openings 310b defined in the second region A2 may respectively overlap the transmission regions NPXAG1, NPXAG2, NPXAR, and NPXAB (see FIG. 4A) defined in the second unit pixel NPX (see FIG. 4B). The first and second openings 310a and 310b may be defined by a side surface of the first light blocking layer 310.

Referring again to FIGS. 5A and 5B, the color filter layer 320 may include a (1-1)-th color filter W320G1 and a (1-2)-th color filter W320R located in the first region A1. The (1-1)-th color filter W320G1 and the (1-2)-th color filter W320R may each be located inside the opening 310a defined in the first region A1. The (1-1)-th color filter W320G1 may transmit light emitted from the (1-1)-th pixel WPXG1, and the (1-2)-th color filter W320R may transmit light emitted from the (1-2)-th pixel WPXR. The color filter layer 320 may include a (1-1)-th color filter overlapping the (1-1)-th color filter W320G1 illustrated in FIG. 5A, and a (1-3)-th color filter overlapping the (1-3)-th pixel WPXB.

The color filter layer 320 may include a (2-1)-th color filter N320G1 and a (2-2)-th color filter N320R located in the second region A2. The (2-1)-th color filter N320G1 and the (2-2)-th color filter N320R may each be located inside the opening 310b defined in the second region A2. The (2-1)-th color filter N320G1 may transmit light emitted from the (2-1)-th pixel NPXG1, and the (2-2)-th color filter N320R may transmit light emitted from the (2-2)-th pixel NPXR. The color filter layer 320 may include a (2-1)-th color filter overlapping the (2-1)-th pixel NPXG1 illustrated in FIG. 4A, and a (2-3)-th color filter overlapping the (2-3)-th pixel NPXB.

The cover inorganic layer 330 may be located in the first region A1 and the second region A2 in common. The cover inorganic layer 330 may cover the color filter layer 320. The cover inorganic layer 330 may protect the color filter layer 320 and the first light blocking layer 310 against moisture and oxygen. The cover inorganic layer 330 may include a silicon nitride layer, a silicon oxynitride layer, a silicon oxide layer, a titanium oxide layer, an aluminum oxide layer, or the like.

The planarization layer 340 may be located in the first region A1 and the second region A2 in common. The planarization layer 340 may cover the first light blocking layer 310 and the color filter layer 320. The planarization layer 340 may include an organic material, and provide a flat surface on an upper surface of the planarization layer 340. The planarization layer 340 may be formed through an inkjet process. According to some embodiments, the planarization layer 340 may be omitted.

The overcoat layer 360 may be located in the first region A1 and the second region A2 in common. The overcoat layer 360 may cover the planarization layer 340. According to some embodiments of the present disclosure, the overcoat layer 360 may be located on the planarization layer 340 in the first region A1. For example, because the second light blocking layer BM2 is not located in the first region A1, a lower surface of the overcoat layer 360 may be in contact with the entire upper surface of the planarization layer 340 in the first region A1.

As illustrated in FIG. 5B, the light control layer 300 according to some embodiments of the present disclosure may include the second light blocking layer 350 located only in the second region A2. The second light blocking layer 350 may be located on the planarization layer 340 and be covered by the overcoat layer 360. The second light blocking layer 350 may correspond to the second light blocking layer BM2 illustrated in FIG. 4A.

The display device DD according to some embodiments of present disclosure may include a functional layer located in the second mode which is a privacy mode so as to emit light at a narrow viewing angle. Accordingly, in the second mode, only the second unit pixels NPX (see FIG. 4A) overlapping the second light blocking layer BM2 may be operated. A plurality of light blocking patterns may be located on the second light blocking layer BM2, and pattern openings 350a may be defined in the respective light blocking patterns. The pattern openings 350a may each overlap a second opening 310b defined in the second region A2 of the first light blocking layer 310.

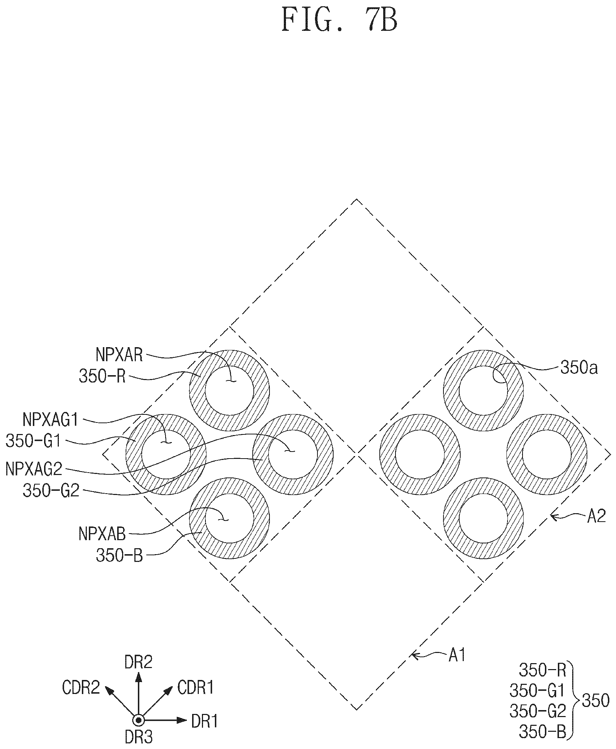

FIG. 7B illustrates a shape of a second light blocking layer 350 located in second regions A2 on a plane (or in a plan view). The second light blocking layer 350 may include light blocking patterns 350-G1, 350-G2, 350-R, and 350-B. A pattern opening 350a may be defined in each of the light blocking patterns 350-G1, 350-G2, 350-R, and 350-B.

The area of the pattern opening 350a may be smaller than the area of the second opening 310b defined in the second region A2 of the first light blocking layer 310. Accordingly, the second unit pixels NPX (see FIG. 4A) overlapping the second region A2 may have narrower viewing angles than the first unit pixels WPX (see FIG. 4A).

The light blocking patterns 350-G1, 350-G2, 350-R, and 350-B may be arranged to be spaced apart from each other along the first oblique direction CDR1 and the second oblique direction CDR2. According to some embodiments, the light blocking patterns 350-G1, 350-G2, 350-R, and 350-B may each have a ring shape. The ring-shaped light blocking patterns 350-G1, 350-G2, 350-R, and 350-B may each surround the second opening 310b on a plane (or in a plan view).

According to some embodiments of the present disclosure, the transmission regions NPXAG1, NPXAG2, NPXAR, and NPXAB, through which light generated from the second unit pixel NPX (see FIG. 4A) is transmitted, may be defined by the pattern openings 350a defined in the second light blocking layer 350.

According to some embodiments, the pattern openings 350a may have the same area. However, embodiments of the present disclosure are not limited thereto. The pattern openings 350a, through which light different from each other is transmitted, may have different areas, and are not limited to any one embodiment.

The second light blocking layer 350 and the first light blocking layer 310 may be formed of the same (or substantially the same) material. Accordingly, the second light blocking layer 350 may prevent or reduce reflection of external light, and include a black coloring agent which absorbs light.

According to some embodiments of the present disclosure, the second unit pixels NPX (see FIG. 4A) may operate both of the first mode which is a normal mode and the second mode which is a privacy mode. In the second mode which is a privacy mode, the first unit pixels WPX (see FIG. 4A) may not operate. As a result, images may be displayed at a narrower viewing angle in the second mode than the first mode.

When comparing FIG. 5A and FIG. 5B, the first region A1 may include the first light blocking layer 310 having the first openings 310a defined therein, but may not include the second light blocking layer 350. Therefore, in the first mode, light emitted from the (1-2)-th light-emitting element WOLR at a first angle AG1 and a second angle AG2 may be visible to both of a user and other people viewing at a high angle.

On the contrary, the second region A2 may include the first light blocking layer 310 having the second openings 310b defined therein, and the second light blocking layer 350 having the pattern openings 350a defined therein. As illustrated above, the areas of the pattern openings 350a are smaller than the areas of the second openings 310b, and thus in the first mode and the second mode, light emitted from a (2-1)-th light-emitting element WPLR at the first angle AG1 and the second angle AG2 may not be visible to other people.

According to some embodiments of the present disclosure, a viewing angle may become narrower in the structure having both the first light blocking layer 310 and the second light blocking layer 350 than the structure having only the first light blocking layer 310. The formation of a narrower viewing angle allows a strong privacy mode to be achieved, and thus a display device DD with enhanced privacy protection may be provided.

FIG. 8 is an enlarged plan view illustrating a portion of a display region according to some embodiments of the present disclosure. FIG. 9 is an enlarged plan view illustrating a portion of a display region according to some embodiments of the present disclosure. The same/similar reference numerals or symbols are used for the components same as/similar to those described in FIGS. 4A to 7B, and a duplicated description thereof will be omitted.

Referring to FIG. 8, the light control layer 300 (see FIG. 5B) according to some embodiments may include a second light blocking layer 350-1 located only in a second region A2. The second light blocking layer 350-1 may be applied to the second light blocking layer BM2 described with reference to FIG. 4A.

The second light blocking layer 350-1 may be located only in the second regions A2. The second light blocking layer 350-1 may include light blocking patterns 350-G1, 350-G2, 350-R, and 350-B, and bridge patterns 350-C. A pattern opening 350a may be defined in each of the light blocking patterns 350-G1, 350-G2, 350-R, and 350-B.

The light blocking patterns 350-G1, 350-G2, 350-R, and 350-B may be arranged to be spaced apart from each other along the first oblique direction CDR1 and the second oblique direction CDR2. According to some embodiments, the light blocking patterns 350-G1, 350-G2, 350-R, and 350-B may each have a ring shape. The ring-shaped light blocking patterns 350-G1, 350-G2, 350-R, and 350-B may each surround the second opening 310b (see FIG. 5B) on a plane (or in a plan view).

The bridge patterns 350-C may connect the adjacent light blocking patterns 350-G1, 350-G2, 350-R, and 350-B. For example, the bridge patterns 350-C may be located between the light blocking patterns 350-G1, 350-G2, 350-R, and 350-B spaced apart from each other along the first oblique direction CDR1 or the second oblique direction CDR2, and connect, as a single pattern, the light blocking patterns 350-G1, and 350-G2, 350-R, and 350-B.

According to some embodiments, the light blocking patterns 350-G1, 350-G2, 350-R, and 350-B are connected to each other via the bridge patterns 350-C, and thus it may be possible to provide the second light blocking layer 350-1 which may prevent or reduce the occurrence of peeling during a subsequent process.

Referring to FIG. 9, the light control layer 300 (see FIG. 5B) according to some embodiments may include a second light blocking layer 350-2 located only in a second region A2. The second light blocking layer 350-2 may be applied to the second light blocking layer BM2 described with reference to FIG. 4A.

The second light blocking layer 350-2 may be located only in the second regions A2. Pattern openings 350a may be defined in the second light blocking layer 350-2. According to some embodiments, the second light blocking layer 350-2 may have a rhombic shape corresponding to a shape of the second region A2. Therefore, the second light blocking layer 350-2 according to some embodiments may be provided as a single pattern.

Embodiments can provide a display device comprising: a display panel which includes a base substrate including a first region and a second region adjacent to the first region, a first unit pixel in the first region, a second unit pixel in the second region, and an encapsulation layer including a first inorganic layer covering the first unit pixel and the second unit pixel, a second inorganic layer, and an organic layer between the first inorganic layer and the second inorganic layer; and a light control layer over the encapsulation layer and including a first light blocking layer in the first region and the second region and having openings which are defined therein and through which light generated from the first unit pixel and the second unit pixel is transmitted, color filters over the openings, and a second light blocking layer including light blocking patterns in which pattern openings each overlapping the opening in the second region are defined, wherein the first inorganic layer includes a (1-1)-th inorganic layer in the first region and a (1-2)-th inorganic layer on the second region, and the (1-1)-th inorganic layer and the (1-2)-th inorganic layer have different stacked structures.

Display devices including a privacy mode may have the issue that a color in the display region shifts, e.g. towards a reddish direction at a high angle.

The display device according to some embodiments of the present disclosure may provide an identical image to a user without occurrence of a color shift phenomenon at a specific angle by varying stacked structures of the (1-1)-th inorganic layer located in the first region and the (1-2)-th inorganic layer located in the second region. This can relatively improve a color sense of the display region at a high angle.

The (1-1)-th inorganic layer may include a number of inorganic layers, e.g. 4, in a stacked structure.

The (1-2)-th inorganic layer may include a number of inorganic layers, e.g. 3, in a stacked structure.

The total thickness of the (1-1)-th inorganic layer may be greater than or the same as the total thickness of the (1-2)-th inorganic layer.

According to some embodiments of the present disclosure, the stacked inorganic layers of the (1-1)-th inorganic layer may each include silicon oxynitride.

The stacked inorganic layers of the (1-1)-th inorganic layer may respectively different refractive indices.

According to some embodiments of the present disclosure, the stacked inorganic layers of the (1-2)-th inorganic layer may each include silicon oxynitride.

The stacked inorganic layers of the (1-2)-th inorganic layer may respectively different refractive indices. A plurality of first regions and second regions may be arranged in the display region DA.

The first regions may be arranged to be spaced apart from each other along a first direction and a second direction.

The second regions may be arranged to be spaced apart from each other along the first direction and the second direction.

According to some embodiments of the present disclosure, the first regions and the second regions may be alternately arranged along a first oblique direction and a second oblique direction. The first regions and the second regions may each be defined to have a rhombic shape on a plane (or in a plan view).

The display device may operates in a first mode or a second mode. For example, the first mode may be a normal mode for displaying a screen at a first viewing angle, and the second mode may be a privacy mode for displaying a screen at a second viewing angle narrower than the first viewing angle. The first viewing angle and the second viewing angle may be defined as angles at which images may be viewed without distortion in image quality with respect to the normal direction of the display surface.

In some embodiments, when the display device operates in the second mode which is a privacy mode, light may not be provided to the transmission regions defined in the first region, but light may be provided only to the transmission regions defined in the second region. Therefore, in the second mode, the images may be invisible when the display device is viewed at an angle exceeding the certain viewing angle.

The display device according to some embodiments may include a functional layer located in the second mode which is a privacy mode so as to emit light at a narrow viewing angle. Accordingly, in the second mode, only the second unit pixels overlapping the second light blocking layer may be operated. A plurality of light blocking patterns may be located on the second light blocking layer, and pattern openings may be defined in the respective light blocking patterns. The pattern openings may each overlap a second opening defined in the second region of the first light blocking layer.

Embodiments can provide an electronic device comprising: a display device according to any of the above mentioned embodiments.

According to some embodiments of the present disclosure, an identical image may be provided to a user without occurrence of a color shift phenomenon at a specific angle. Therefore, it may be possible to provide a display device with relatively improved display quality and reliability.

Although aspects of some embodiments of the present disclosure have been described, it is understood that embodiments according to the present disclosure should not be limited to these embodiments but various changes and modifications can be made by one ordinary skilled in the art within the scope of the present disclosure as hereinafter claimed.

Therefore, the technical scope of the present disclosure are not limited to the contents described in the detailed description of the specification, but should be determined by the appended claims, and their equivalents.

## Claims

1. A display device comprising:
a display panel which includes a base substrate including a first region and a second region adjacent to the first region, a first unit pixel in the first region, a second unit pixel in the second region, and an encapsulation layer including a first inorganic layer covering the first unit pixel and the second unit pixel, a second inorganic layer, and an organic layer between the first inorganic layer and the second inorganic layer; and
a light control layer over the encapsulation layer and including a first light blocking layer in the first region and the second region and having openings which are defined therein and through which light generated from the first unit pixel and the second unit pixel is transmitted, color filters over the openings, and a second light blocking layer including light blocking patterns in which pattern openings each overlapping the opening in the second region are defined,
wherein the first inorganic layer includes a (1-1)-th inorganic layer in the first region and a (1-2)-th inorganic layer on the second region, and
the (1-1)-th inorganic layer and the (1-2)-th inorganic layer have different stacked structures.

2. **The** display device of claim 1, wherein the (1-1)-th inorganic layer comprises (1-1)-th to (1-4)-th layers sequentially stacked, and
the (1-2)-th inorganic layer comprises (2-1)-th to (2-3)-th layers sequentially stacked.

3. The display device of claim 2, wherein the (1-1)-th to (1-4)-th layers included in the (1-1)-th inorganic layer, and the (2-1)-th to (2-3)-th layers included in the (1-2)-th inorganic layer have different refractive indices, and each comprise silicon oxynitride.

4. The display device of claim 3, wherein in the (1-1)-th inorganic layer, the (1-1)-th layer has a thickness in a range of 80 nm to 120 nm, the (1-2)-th layer has a thickness in a range of 700 nm to 1100 nm, the (1-3)-th layer has a thickness in a range of 50 nm to 90 nm, and the (1-4)-th layer has a thickness in a range of 60 nm to 100 nm.

5. **The** display device of claim 3 or 4, wherein in the (1-2)-th inorganic layer, the (2-1)-th layer has a thickness in a range of 800 nm to 1300 nm, the (2-2)-th layer has a thickness in a range of 50 nm to 90 nm, and the (2-3)-th layer has a thickness in a range of 60 nm to 100 nm.

6. **The** display device of any one of claims 3 to 5, wherein the (1-4)-th layer and the (2-3)-th layer have oxygen content ratios greater than those of the (1-1)-th, (1-3)-th, (2-1)-th and (2-2)-th layers.

7. **The** display device of any one of claims 2 to 6, wherein a refractive index of the (1-1)-th layer is smaller than refractive indices of the (1-2)-th layer and the (1-3)-th layer, and is greater than a refractive index of the (1-4)-th layer, and
a refractive index of the (1-3)-th layer is smaller than a refractive index of the (1-2)-th layer, and is greater than a refractive index of the (1-4)-th layer.

8. The display device of claim 7, wherein a refractive index of the (2-1)-th layer is the same as a refractive index of the (1-2)-th layer,
a refractive index of the (2-2)-th layer is the same as a refractive index of the (1-3)-th layer, and
a refractive index of the (2-3)-th layer is the same as a refractive index of the (1-4)-th layer.

9. The display device of any one of claims 2 to 8, wherein refractive indices of the (1-4)-th layer and the (2-3)-th layer are the same as a refractive index of the organic layer.

10. The display device of any one of claims 1 to 9, wherein an area of a pattern opening from among the pattern openings is smaller than an area of the opening.

11. The display device of any one of claims 1 to 10, wherein the first unit pixel comprises (1-1)-th pixels each configured to provide first color light and spaced apart from each other along a first direction,
a (1-2)-th pixel configured to provide second color light different from the first color light and spaced apart from the (1-1)-th pixels in oblique directions with respect to the first direction, and
a (1-3)-th pixel configured to provide third color light different from the first color light and the second color light, spaced apart from the (1-2)-th pixel along a second direction crossing the first direction, and spaced apart from the (1-1)-th pixels in the oblique directions, and
the second unit pixel comprises (2-1)-th pixels each configured to provide the first color light and spaced apart from each other along the first direction,
a (2-2)-th pixel configured to provide the second color light and spaced apart from the (2-1)-th pixels in the oblique directions, and
a (2-3)-th pixel configured to provide the third color light, spaced apart from the (2-2)-th pixel along the second direction, and spaced apart from the (2-1)-th pixels in the oblique directions;
optionally wherein the first unit pixel and the second unit pixel are each provided in plurality, four different second unit pixels are adjacent to each other with respect to the one first unit pixel in the oblique directions, and four different first unit pixels are adjacent to each other with respect to the one second unit pixel in the oblique directions.

12. **The** display device of claim 11, wherein the (1-1)-th to (1-3)-th pixels, and the (2-1)-th to (2-3)-th pixels each comprise a first electrode, a second electrode, and a light-emitting pattern between the first electrode and the second electrode, and
the display panel further comprises a protective layer between the second electrode and the first inorganic layer;
optionally wherein a refractive index of the protective layer is greater than refractive indices of the (1-1)-th inorganic layer and the (1-2)-th inorganic layer;
optionally wherein the display panel comprises a pixel-defining film in which display openings exposing at least a portion of each of the first electrodes and having light-emitting patterns located therein are defined, and the openings and the pattern openings overlap the display openings.

13. **The** display device of any one of claims 1 to 12, wherein the openings each have either of a circular shape or an oval shape;
optionally wherein the pattern openings each have a circular shape, and areas of the openings are greater than areas of the pattern openings in a plan view;
further optionally wherein the light blocking patterns each have a ring shape.

14. The display device of any one of claims 1 to 13, wherein the light control layer comprises a planarization layer covering the color filters and below the second light blocking layer, and
an overcoat layer covering the second light blocking layer and on the planarization layer.

15. An electronic device comprising:
a display device according to any one of claims 1 to 14.
